Europäisches Patentamt

European Patent Office

Office européen des brevets

(19)

(11) Publication number: **0 105 985**
A1

(12) **EUROPEAN PATENT APPLICATION**

(21) Application number: **82305424.2**

(22) Date of filing: **12.10.82**

(51) Int. Cl.³: **H 01 L 27/08, H 01 L 27/02**

(43) Date of publication of application: **25.04.84**
Bulletin 84/17

(84) Designated Contracting States: **DE GB NL**

(71) Applicant: **MITSUBISHI DENKI KABUSHIKI KAISHA, 2-3, Marunouchi 2-chome Chiyoda-ku, Tokyo 100 (JP)**

(72) Inventor: **Ohkura, Isao c/o Mitsubishi Denki K.K., LSI Kenkyusho 1, Mizuhara 4-chome, Itami-shi Hyogo-ken (JP)**

(74) Representative: **Wright, Peter David John et al, R.G.C. Jenkins & Co. 12-15, Fetter Lane, London EC4A 1PL (GB)**

(54) Complementary metal-oxide semiconductor integrated circuit device.

(57) A complementary metal-oxide semiconductor integrated circuit device comprises a plurality of pairs of N- and P-channel metal-oxide semiconductor transistors (Q1a, Q2a, Q3a, Q4a; Q1b, Q2b, Q3b, Q4b). The plurality of pairs are juxtaposed with respect to each other and no isolation areas are formed between the respective pairs. A single pair or a series of pairs out of the plurality of pairs constitute a functional device (30). The gate electrodes (311a, 311b) of the N- and P-channel metal-oxide semiconductor transistors in the pair adjacent to the functional defice (30) are held in relatively negative (GND) and positive ($V_{DD}$) potential voltages, respectively, so that the functional device (30) is electrically isolated from the remaining portions.

TITLE OF THE INVENTION

Complementary Metal-Oxide Semiconductor Integrated

Circuit Device

BACKGROUND OF THE INVENTION

Field of the Invention

The present invention relates to a complementary metal-oxide semiconductor integrated circuit device and more particularly, relates to an improvement of an arrangement of a unit cell and a manner of isolation between functional devices in a complementary metal-oxide semiconductor integrated circuit device in which a plurality of unit cells, such as a transistor array and a gate array are juxtaposed.

Description of the Prior Art

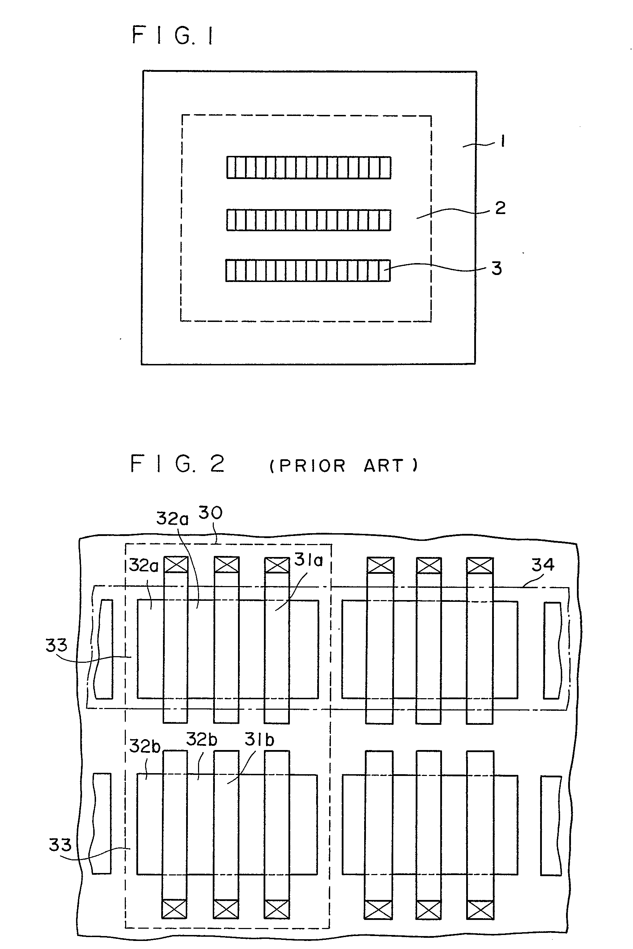

Fig. 1 shows an arrangement of a gate array in a conceptual manner. The gate array comprises an input-output circuit portion 1, an internal wiring portion 2 and an internal gate circuit portion 3. The internal gate circuit portion 3 is adapted such that a plurality of unit cells are juxtaposed. Generally, the internal gate circuit portion 3 may include a kind of unit cell or may include a plurality of kinds of unit cells. A functional device having a logic function is structured by a single or a plurality of unit cells, or a plurality of functional devices are formed within a unit cell. A plurality of functional devices thus structured are interconnected by a internal wiring provided in the internal wiring portion 2 and, in addition, are connected to an input-output circuit existing in the input-output circuit portion 1, so that a logic circuit is structured.

Fig. 2 shows an example of a conventional arrangement of unit cells. A unit cell 30 encircled in a dotted line is structured to include gate regions 31a and 31b, regions 32a and 32b to become a source or a drain, which constitutes a metal-oxide semiconductor transistor, and isolation regions 33 for electrically isolating the unit cell 30 from another unit cell adjacent thereto. A portion 34 encircled in a dotted chain line has a conductivity type opposite to that in a semiconductor substrate other than this portion 34, which is generally called a well. Usually, an N-type semiconductor substrate is used and thus P-type impurities are introduced into the portion 34. As a result, an N-channel metal-oxide semiconductor transistor is formed in the portion 34 encircled in a dotted chain line and a P-channel metal-oxide semiconductor transistor is formed on the semiconductor substrate side outside the portion 34. In the Fig. 2 example, three pairs of gate regions 31a and 31b are disposed in the unit cell 30, and thus a functional gate having a maximum of three inputs can be structured. However, in the Fig. 2 example, if a functional gate, a flip-flop and the like having four or more inputs are desired, a plurality of unit cells 30 must be used.

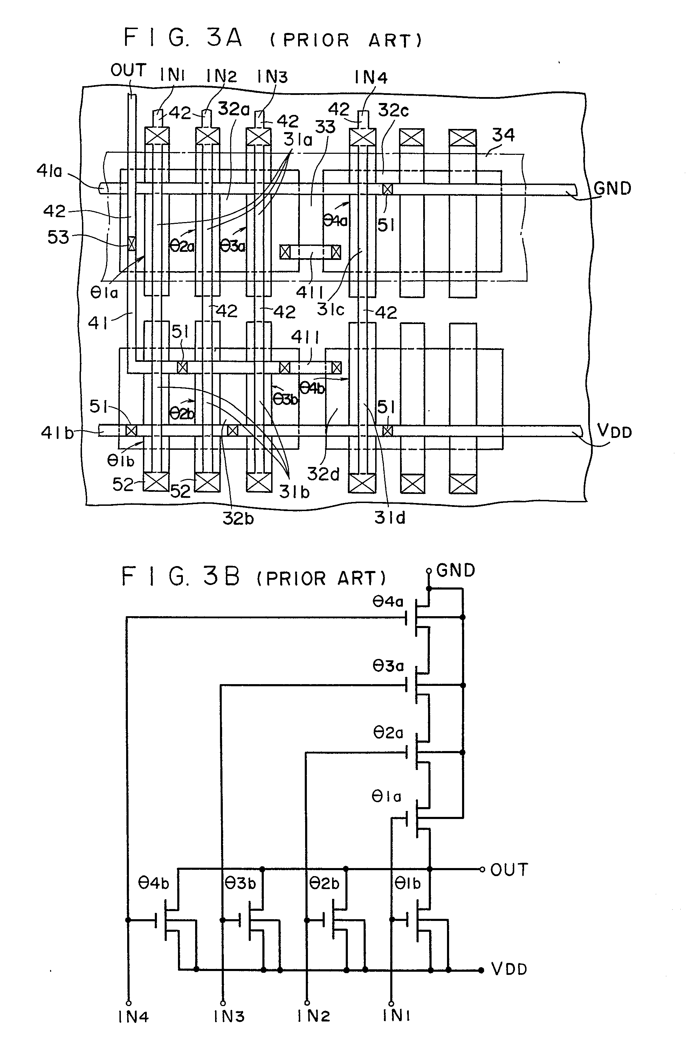

Fig. 3A shows a schematic diagram of a NOR gate having four inputs, which is structured by the above described Fig. 2 example, and Fig. 3B shows a equivalent circuit of the NOR gate having four inputs in Fig. 3A. As seen from Figs. 3A and 3B, interconnections between metal-oxide semiconductor transistors as included in the NOR gate having four inputs are made by aluminum wiring 41a, 41b and 411 of the first layer, and another aluminum wiring 42 of the second layer is used for providing four inputs and one output. More particularly, four N-channel metal-oxide semiconductor transistors Q1a, Q2a, Q3a and Q4a are connected in series, wherein the ground potential GND is applied to the source region of the transistor Q4a through the first layer aluminum wiring 41a. On the other hand, four P-channel metal-oxide semiconductor transistors Q1b, Q2b, Q3b and Q4b are connected in parallel, to which the $V_{DD}$ potential is applied through the first layer aluminum wiring 41b. The gate regions of the P- and N-channel transistors in each pair are connected in common by the second layer aluminum wiring 42. Referring to Fig. 3A, four inputs IN1 to IN4 are applied to the gate electrodes 31a, 31b, 31c and 31d in the N-channel and P-channel metal-oxide semiconductor transistors through the second layer aluminum wiring 42 from the internal wiring portion 2 as shown in Fig.1, and the output OUT is sent out to the internal wiring portion 2 through the second layer aluminum wiring 42. The

- 3 -

first layer aluminum wiring 41a and 41b are connected to the N-type or P-type source or drain regions 32a, 32c, and 32b, 32d formed in the surface of the semiconductor substrate, by contact holes 51. The connection of the second layer aluminum wiring 42 and the gate regions 31a, 31b, 31c and 31d are made at the connecting point 52.

With such a conventional structure, there must be provided an isolation region 33 for electrically isolating a unit cell 30 from another unit cell adjacent thereto. Therefore, for example, if and when the NOR gate having four inputs is structured, three pairs of gate regions 31a and 31b and a pair of gate regions 31c and 31d are needed, which means that it is necessary to combine two unit cells 30. More particularly, two wirings 411 are needed for the purpose of making electrically equal potential the source or drain regions 32a and 32c in the N-channel metal-oxide semiconductor transistors and the source or drain regions 32b and 32d in the P-channel metal-oxide semiconductor transistors included in both unit cells 30. In addition, the source or drain regions in the portions to be connected by the wirings 411 become larger in the area than the source or the drain regions in the remaining portions and thus a stray capacity between a semiconductor substrate or the above described well and such regions becomes larger and the operating speed of a functional gate becomes late.

SUMMARY OF THE INVENTION

The present invention comprises a metal-oxide semiconductor integrated circuit device including a plurality of pairs of N- and P-channel metal-oxide semiconductor transistors having a gate electrode. The plurality of pairs are juxtaposed with respect to each other, without disposing any isolation areas between the respective pairs, and also disposed such that the N-channel metal-oxide semiconductor transistor and P-channel metal-oxide semiconductor transistor in each pair of the plurality of pairs adjoin the N-channel metal-oxide semiconductor transistor and P-channel metal-oxide semiconductor transistor in the pair adjacent thereto, respectively. A single pair or a series of pairs out of the plurality of pairs constitute a functional device. The gate electrodes of the N- and P-channel metal-oxide semiconductor transistors in the pair adjacent to the functional device are held in relatively negative and positive potential voltages so that the N-channel metal-oxide semiconductor transistor and P-channel metal-oxide semiconductor transistor are rendered non-conductive so as to isolate electrically the functional device from the remaining portions.

Accordingly, a principal object of the present invention is to provide a complementary metal-oxide semiconductor integrated circuit device having higher density of integration and higher operating speed by structuring any size of unit cells without forming isolations areas.

The object and other objects, features, aspects and advantages of the present invention will become more apparent from the following detailed description of the present invention when taken in conjunction with the accompanying drawings.

BRIEF DESCRIPTION OF THE DRAWINGS

Fig. 1 shows an arrangement of a gate array in a conceptual manner;

Fig. 2 shows one example of a conventional unit cell arrangement;

Fig. 3A shows an arrangement of a NOR gate having four inputs by using the Fig. 2 example;

Fig. 3B is a equivalent circuit of the Fig. 3A arrangement;

Fig. 4 is an arrangement of one embodiment of the present invention; and

Fig. 5 is an arrangement of a NOR gate having four inputs by using the Fig. 4 embodiment.

DETAILED DESCRIPTION OF THE PREFERRED EMBODIMENTS

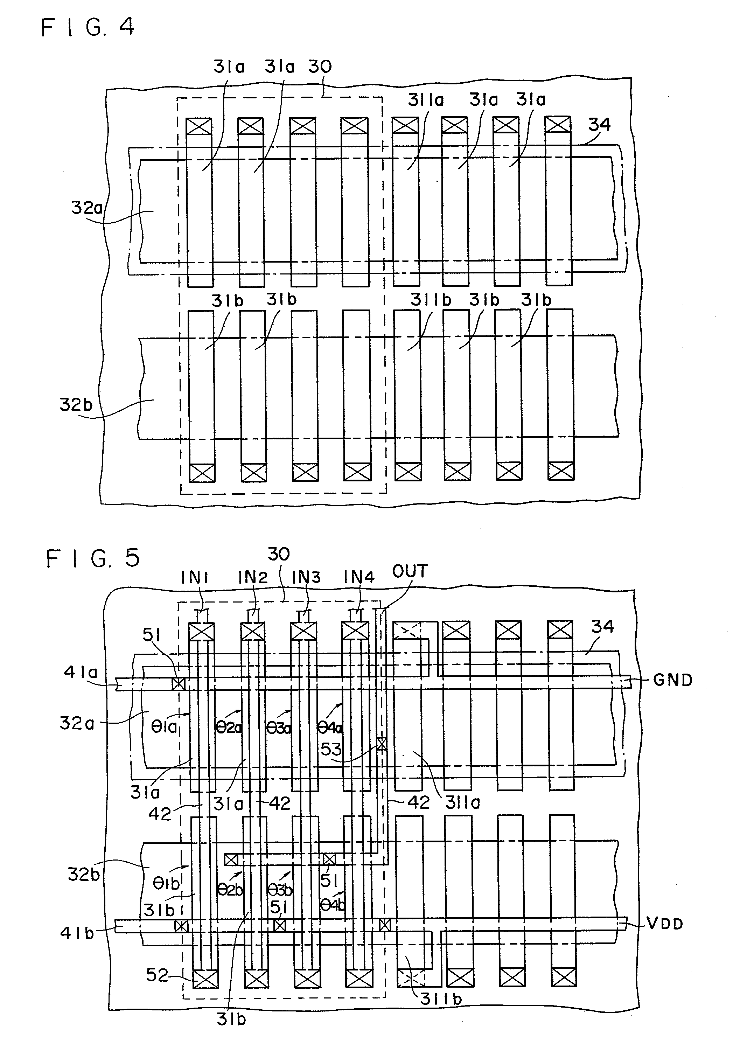

Fig. 4 shows an arrangement of one embodiment of the present invention, wherein the same portions as the above described conventional example are denoted by the same reference numerals and thus the explanation thereof will be omitted. As seen from the Fig. 4 embodiment, a unit cell 30 can be structured by using any number of complementary metal-oxide semiconductor transistors, since no isolation regions for isolating a unit cell from another unit cell adjacent thereto. More particularly, assuming that a unit cell 30 is structured by four pairs of metal-oxide semiconductor transistors as shown in Fig. 4, gate regions in a pair of metal-oxide semiconductor transistors adjacent to the unit cell 30, that is, 311a and 311b, which are exactly the same as the other gate regions 31a and 31b, are connected to a ground potential and a positive source potential, respectively, so that the metal-oxide semiconductor transistors corresponding to the gate regions 311a and 311b are always rendered non-conductive to isolate the unit cell 30 from the adjacent regions. More particularly, the metal-oxide semiconductor transistor corresponding to the gate region 311a is an N-channel metal-oxide semiconductor transistor, as described in the foregoing, and thus can be rendered non-conductive by applying a relatively negative potential to the gate electrode thereof. On the other hand, the metal-oxide semiconductor transistor corresponding to the gate region 311b is a P-channel metal-oxide semiconductor transistor and thus can be rendered non-conductive by applying relatively positive potential to the gate electrode thereof.

Fig. 5 shows a specific arrangement of a NOR gate having four inputs by using the Fig. 4 embodiment, wherein the same portions as a conventional example in Fig. 3 are denoted by the same reference numerals and thus it is believed that the Fig. 5 embodiment can be readily understood from the Fig. 4 embodiment. As shown in Fig. 5, the gate area 311a in the N-channel metal-oxide semiconductor transistor adjacent to the unit cell 30 is connected to the first layer aluminum wiring 41a which, in turn, is connected to a ground potential, and the gate region 311b in the P-channel metal-oxide semiconductor transistor adjacent to the unit cell 30 is connected to the first layer aluminum wiring 41b which, in turn, is connected to a positive potential source, $V_{DD}$. Therefore, the N-channel metal-oxide semiconductor transistor having a gate region 311a and the P-channel metal-oxide semiconductor transistor having the gate region 311b are both rendered non-conductive all the time, and thu act as an isolation area.

In the above described embodiment, although a gate with four inputs are illustrated as an example, a gate having any number of inputs can be structured as a single unit cell. In the Fig. 4 embodiment, a gate having seven inputs can be structured as a single unit cell. This concept applies to the case where a number of unit cells are needed, such as a flip-flop and the like. Although the shape or configuration

0105985

of the gate regions included in a unit cell is shown as identical, a different shape or configuration or configurations may be included in a unit cell. In addition, as a matter of course, a plurality of kinds of unit cells may be implemented in a single integrated circuit. Furthermore, in the above described embodiment, an N-type semiconductor substrate may be used, however, a P-type substrate may be also used.

As described in the foregoing, in accordance with the inventive complementary metal-oxide semiconductor integrated circuit device wherein a plurality of pairs of P- and N-channel metal-oxide semiconductor transistors are juxtaposed with respect to each other, without disposing any isolation areas between the respective pairs, a functional device is structured by a desired number of pairs out of the plurality of pairs and the gate electrodes of the P- and N-channel metal-oxide semiconductor transistors in the pair adjacent to the functional device are held in relatively positive and negative potential voltages so that P- and N-channel metal-oxide semiconductor transistors are rendered non-conductive so as to isolate electrically the functional device from the remaining portions, there is no necessity to include isolation regions, and wiring between unit cells across the isolation regions. Therefore, the complementary metal-oxide semiconductor transistor pair can be effectively

- 9 -

utilized and the density of integration of the device can be enhanced, with a result that an enhancement of an operation speed can be expected.

Although the present invention has been described and illustrated in detail, it is clearly understood that the same is by way of illustration and example only and is not to be taken by way of limitation, the spirit and scope of the present invention being limited only by the terms of the appended claims.

CLAIMS:

1. A metal-oxide semiconductor integrated circuit device comprising:

a plurality of pairs of P- and N-channel metal-oxide semiconductor transistors (Q1a, Q2a, Q3a, Q4a; Q1b, Q2b, Q3b, Q4b) having gate electrodes (31a; 31b),

said plurality of pairs being juxtaposed with respect to each other and being disposed such that the P-channel metal-oxide semiconductor transistor and N-channel metal-oxide semiconductor transistor in each pair of said plurality of pairs adjoin the P-channel metal-oxide semiconductor transistor and N-channel metal-oxide semiconductor transistor in the pair adjacent thereto, respectively, and

a predetermined number of pairs out of said plurality of pairs constituting a functional device (30) having a logical function,

characterised in that

there are no isolation areas between the respective pairs of said plurality of pairs, and

the gate electrodes(31a,31b)of the P- and N-channel metal-oxide semiconductor transistors in the pair adjacent to said said functional device (30) are held in relatively positive and negative potential voltages, respectively so that said P- and N-channel metal-oxide semiconductor transistors in said pair adjacent to said functional device are rendered non-conductive so as to electrically isolate said functional device from the remaining portions of the metal-oxide semiconductor integrated circuit device.

2. A metal-oxide semiconductor integrated circuit device comprising a plurality of pairs of P- and N-channel metal-oxide semiconductor transistors (Q1a, Q2a, Q3a, Q4a; Q1b, Q2b, Q3b, Q4b), a group (30) of said pairs being arranged to provide a logic function and being electrically isolated from the other said pairs, characterised in that said group of pairs of transistors is electrically isolated from said other pairs of transistors by a respective one of said other pairs situated adjacent to said group of pairs, said respective one of said other pairs of transistors having gate electrodes (311a, 311b) which are held in relatively positive and negative potential voltages, respectively.

F I G. 1

F I G. 2     (PRIOR ART)

0105985

## FIG. 3A (PRIOR ART)

## FIG. 3B (PRIOR ART)

F I G. 4

31a  31a  30                31Ia  31a  31a
                                              34
32a

31b   31b           31Ib  31b  31b

32b

F I G. 5

                    30
        IN1  IN2  IN3  IN4   OUT
51
                                        34
41a                                        — GND
32a
      θ1a   θ2a   θ3a   θ4a
                      53
31a
      31a   42              42  31Ia
42
32b
      θ1b   θ2b   θ3b   θ4b
                      51
31b                51
41b                                        — VDD
52
                      31Ib
        31b

# EUROPEAN SEARCH REPORT

Application number

EP 82 30 5424

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | ELECTRONIC DESIGN, vol. 30, no. 4, February 1982, pages 71-78, Waseca, MN, Denville, NJ, USA D. BURSKY: "Fabrication gains feed the growth of digital VLSI" * Figure 5 * | 1,2 | H 01 L 27/08 H 01 L 27/02 |
| | --- | | |
| A | US-A-3 967 988 (U.S. DAVIDSOHN) * Abstract; figure 16 * | 1-2 | |
| | --- | | |
| A | US-A-4 063 274 (A.G.F. DINGWALL) * Abstract; figure 1 * | 1-2 | |
| | ----- | | |

TECHNICAL FIELDS SEARCHED (Int. Cl. ³)

H 01 L

The present search report has been drawn up for all claims

| Place of search THE HAGUE | Date of completion of the search 14-06-1983 | Examiner KORAHNKE G.J. |
|---|---|---|

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82